# EUROPEAN PATENT APPLICATION

(11) **EP 2 006 897 A1**
(43) Date of publication of application: **24.12.2008**
(21) Application number: 07740818.5
(22) Date of filing: 02.04.2007
(51) Int. Cl.: H01L 21/56, B29C 45/02, B29C 45/14, B29C 45/26

(54) **METHOD OF RESIN ENCAPSULATION MOLDING FOR ELECTRONIC PART AND RESIN ENCAPSULATION MOLDING APPARATUS FOR ELECTRONIC PART**

(30) Priority: 11.04.2006 JP 2006108864; 11.04.2006 JP 2006108865
(71) Applicant: Towa Corporation, Kyoto 6018105 (JP)
(72) Inventor: MAEDA, Keiji, c/o Towa Corporation, Kyoto-shi, Kyoto 601-8105 (JP); TOKUYAMA, Hideki, c/o Towa Corporation, Kyoto-shi, Kyoto 601-8105 (JP); ONISHI, Yohei, c/o Towa Corporation, Kyoto-shi, Kyoto 601-8105 (JP)
(74) Representative: Matthews, Heather Clare
(86) International application number: PCT/JP2007/057382
(87) International publication number: WO 2007/119644

(57) **Abstract**

A method and an apparatus for resin-sealing and resin-molding an electronic component, capable of reliably preventing formation of a void within a molded package, are provided. The resin-sealing and resin-molding apparatus includes a first die (111), a second die (112), a pot block (140), and a pressure reduction mechanism. The first die (111) has a first die surface, and a substrate (400) on which the electronic component is mounted is attached to the first die. The second die (112) has a second die surface opposed to the first die surface and a cavity (114) receiving the electronic component. The pot block (140) injects a resin material through a gap while the first die (111) and the second die (112) are fastened to each other. When the resin material is injected, the pressure reduction mechanism produces vacuum in a space formed between the first die surface, the second die surface, and the pot block (140).

## Description

### TECHNICAL FIELD

The present invention relates to a method for sealing and molding an electronic component of a relatively small size such as a semiconductor chip with a resin material and an apparatus for resin-sealing and resin-molding an electronic component used for performing this method, and particularly to improvement in quality of resin-sealing in using a resin-sealing and resin-molding die structured such that a pot block for the die for resin-sealing and resin-molding the electronic component is arranged in a manner freely joined to and separated from a side surface of the die.

### BACKGROUND ART

A semiconductor package (hereinafter abbreviated as a package) obtained by sealing and molding an electronic component of a relatively small size such as a semiconductor chip (hereinafter abbreviated as an electronic component) with a resin material has particularly been demanded to have higher functions in recent years. Specifically, for example, higher integration, higher reliability and reduction in size and weight thereof have strongly been demanded, as in what is called a MAP type large-sized substrate.

Accordingly, in molding the semiconductor package, it should be resin-sealed and resin-molded such that an outer shape thereof is reduced in size and weight as much as possible while maintaining quality of a highly-integrated, resin-sealed and resin-molded product.

In order to maintain the quality of the package which is a resin-sealed and resin-molded product in such resin-sealing and resin-molding, it is important to enhance adhesion (or contact) between the resin material for sealing the electronic component and a lead frame, a substrate or the like (hereinafter abbreviated as a substrate) to which the electronic component has been attached.

Here, in resin-sealing and resin-molding the electronic component on the substrate, the following steps are generally performed. Initially, the substrate is set to a prescribed position in a cavity portion provided in a die matching surface (a parting line surface; hereinafter abbreviated as a P.L surface) of the resin-sealing and resin-molding die. Thereafter, clamping for fastening the P.L surfaces to each other is performed. Then, a molten resin material is injected into the cavity. The electronic component is thus sealed in the package molded in conformity with the cavity shape.

Since the cavity portion provided in the P.L surface, a passage for transferring the molten resin material, or the like is formed as an in-die space portion, air, moisture, gases generated during heating and melting of the resin material, and the like that remain in the in-die space portion are introduced into the molten resin material. This results in formation of voids (bubbles) within the package, which in turn proves to be a factor of lower adhesion between the substrate and the package. Therefore, by producing vacuum (reducing pressure) in the space formed within the die prior to injection of the molten resin material into the cavity, air or the like that remains in the space within the die is positively exhausted to the outside (see, for example, Japanese Patent Laying-Open No. 05-008250 (Patent Document 1)).

In addition, mainly in order to improve an effective utilization ratio of the resin material used for resin-sealing and resin-molding the electronic component, such a structure that a molten resin injection cylinder (a pot for supplying the resin material) is joined to and separated from a side surface of a die when the P.L surfaces of the resin-sealing and resin-molding dies are matched has been known (see, for example, Japanese Patent Laying-Open No. 59-052842 (Patent Document 2)).
Patent Document 1: Japanese Patent Laying-Open No. 05-008250
Patent Document 2: Japanese Patent Laying-Open No. 59-052842

### DISCLOSURE OF THE INVENTION

### PROBLEMS TO BE SOLVED BY THE INVENTION

In the invention where vacuum is produced in the space within the die prior to injection of the molten resin material into the cavity described above (Patent Document 1), air or the like that remains in the space within the die is positively exhausted to the outside, so that formation of voids within the package due to presence of the remaining air or the like is prevented. In addition, such a function and effect that lowering in adhesion between the substrate and the package is unlikely can be expected.

In addition, in the structure that the molten resin injection cylinder (pot) described above is joined to and separated from the side surface of the die when the P.L surfaces of the resin-sealing and resin-molding dies are matched (Patent Document 2), a resin passage for transferring the molten resin material is made shorter. Thus, the effective utilization ratio of the resin material can be improved.

On the other hand, production of vacuum in the space within the die in the structure that the molten resin injection cylinder (pot) is joined to and separated from the side surface of the die when the P.L surfaces of the resin-sealing and resin-molding dies are matched (Patent Document 2) has not been disclosed.

Here, an object of the present invention is to provide a method and an apparatus for resin-sealing and resin-molding an electronic component, capable of reliably preventing formation of a void within a molded package.

### MEANS FOR SOLVING THE PROBLEMS

A method of resin-sealing and resin-molding an electronic component according to the present invention includes a preparation step, a supply step, a clamping step, a joint step, a pressure reduction step, an injection step, a separation step, a molding step, and a die unfastening step. In the preparation step, a resin-molding apparatus including a die assembly including a first die having a first die surface and a second die having a second die surface opposed to the first die surface and a cavity receiving the electronic component is prepared. In the supply step, a substrate before resin-sealing, to which the electronic component has been attached, is supplied to a prescribed position in a set surface. In the clamping step, the electronic component and a peripheral portion thereof on the substrate before resin-sealing are inserted into the cavity provided between the first die surface and the second die surface, by clamping the die assembly. In the joint step, a pot block injecting a resin material is joined to a side surface of the die assembly after the clamping step. In the pressure reduction step, vacuum is produced in a space formed between the first die surface, the second die surface and the pot block after the joint step. In the injection step, the resin material is directly injected from the pot block into the cavity. In the separation step, the pot block is separated from the die assembly. In the molding step, the electronic component and the peripheral portion thereof fitted into the cavity are sealed with the resin material by curing the resin material. In the die unfastening step, the first die and the second die are unfastened after the molding step and a substrate after resin-sealing after the resin-sealing and resin-molding step is taken out.

In addition, in the method of resin-molding an electronic component according to the present invention, preferably, in the supply step, a single substrate before resin-sealing and resin-molding is supplied in between the first die surface and the second die surface.

In addition, in the method of resin-molding an electronic component according to the present invention, preferably, in the supply step, an end surface of the substrate before resin-sealing and a side surface of the die assembly are positioned flush with each other.

In addition, in the method of resin-molding an electronic component according to the present invention, preferably, in the preparation step, the resin-molding apparatus in which a plurality of die assemblies are arranged in a stacked manner is prepared, and in the clamping step, pressure is simultaneously applied to the plurality of die assemblies.

In addition, an apparatus for resin-sealing and resin-molding an electronic component according to the present invention includes a first die, a second die, a pot block, and a pressure reduction mechanism. The first die has a first die surface, and a substrate carrying the electronic component is attached to the first die. The second die has a second die surface opposed to the first die surface and has a cavity receiving the electronic component. The pot block injects a resin material through a side surface of a die assembly while the die assembly including the first die and the second die is fastened. The pressure reduction mechanism produces vacuum in a space formed between the first die surface, the second die surface and the pot block when the resin material is injected.

In addition, in the apparatus for resin-sealing and resin-molding an electronic component according to the present invention, preferably, a substrate supply portion supplied with a single substrate before resin-sealing is provided in the first die.

In addition, in the apparatus for resin-sealing and resin-molding an electronic component according to the present invention, preferably, in supplying the substrate before resin-sealing into the cavity, a supply mechanism supplying the substrate before resin-sealing such that an end surface of the substrate before resin-sealing and a side surface of the die assembly including the first die and the second die are positioned flush with each other is provided.

In addition, in the apparatus for resin-sealing and resin-molding an electronic component according to the present invention, preferably, a plurality of die assemblies are arranged in a stacked manner, and a pressure application apparatus simultaneously applying pressure to the plurality of die assemblies is provided.

In addition, in the apparatus for resin-sealing and resin-molding an electronic component according to the present invention, preferably, the pot block includes a pot containing the resin material and a plunger pushing the resin material supplied into the pot into the cavity, and the apparatus for resin-sealing and resin-molding an electronic component further includes a resin coating layer having a sealing function at the first die surface, the second die surface, and a joint surface between the pot block and the die assembly including the first die and the second die.

In addition, in the apparatus for resin-sealing and resin-molding an electronic component according to the present invention, preferably, the pressure reduction mechanism includes an exhaust path connected to the space and provided in the pot block.

### EFFECTS OF THE INVENTION

By adopting the method and the apparatus for resin-sealing and resin-molding the electronic component according to the present invention, formation of voids within a molded package can reliably be prevented, and hence a resin-sealed and resin-molded product of electronic component of high quality and high reliability can be molded.

### BRIEF DESCRIPTION OF THE DRAWINGS

Fig. 1 is a partially cut-away cross-sectional view showing a main portion of a resin-sealing and resin-molding apparatus for performing a method of resin-sealing and resin-molding an electronic component according to the present invention.
Fig. 2 is a partially cut-away vertical cross-sectional view schematically showing a main portion of a resin-sealing and resin-molding portion in the resin-sealing and resin-molding apparatus in Fig. 1, and illustrates an example where a substrate before resin-sealing and resin-molding is set to a prescribed position in a die-matching surface (P.L surface) of each unfastened die assembly and a resin material is supplied into a pot.
Fig. 3 is a partially cut-away cross-sectional view along the line III-III in Fig. 2 showing the resin-sealing and resin-molding portion corresponding to Fig. 2, and schematically shows relation of arrangement of sealing members provided on the die-matching surface of the die assembly and a pot block.
Fig. 4 is a partially cut-away cross-sectional view of the resin-sealing and resin-molding portion corresponding to Fig. 2, and shows a state that the substrate before resin-sealing and resin-molding is set onto the die-matching surface and a state of supply of the resin material into the pot.
Fig. 5 is a partially cut-away cross-sectional view of the resin-sealing and resin-molding portion corresponding to Fig. 2, and shows a state of clamping of each die assembly, a state of joint of a sealing member disposed at a front end portion of the pot block to a side surface of each die assembly, and a state that remaining air or the like within a space formed between a first die surface and a second die surface of each die assembly and between each die assembly and the pot block is forcibly exhausted to the outside of the die assembly.
Fig. 6 is a partially cut-away cross-sectional view of the resin-sealing and resin-molding portion corresponding to Fig. 5, and shows a completely clamped state where the first die surface and the second die surface of each die assembly are completely fastened to each other and each die assembly and the front end portion of the pot block are completely fastened to each other.
Fig. 7 is a partially cut-away cross-sectional view of the resin-sealing and resin-molding portion corresponding to Fig. 6, and shows a state of pressure application and transfer of the resin material within the pot.
Fig. 8 is a partially cut-away cross-sectional view of the resin-sealing and resin-molding portion corresponding to Fig. 7, and shows a state that the pot block is moved backward after resin-sealing and resin-molding.
Fig. 9 is a partially cut-away cross-sectional view of the resin-sealing and resin-molding portion corresponding to Fig. 8, and shows an unfastened state of each die assembly.
Fig. 10 is a partially cut-away cross-sectional view of the resin-sealing and resin-molding portion corresponding to Fig. 9, and shows a state of taking out the substrate after resin-sealing and resin-molding.
Fig. 11 is a partially cut-away cross-sectional view of the resin-sealing and resin-molding portion, and shows another exemplary shape and another exemplary structure of a sealing member disposed at the front end portion of the pot block.

### DESCRIPTION OF THE REFERENCE SIGNS

100 resin-sealing and resin-molding portion; 110 die assembly; 110a side surface; 111 first die; 112 second die; 113 set surface; 114 cavity; 115 transfer passage; 116 pin; 120 die unfastening and fastening mechanism; 130 pressing mechanism; 140 pot block; 141 pot; 142 plunger; 150 reciprocating drive mechanism; 200 substrate supply and take-out mechanism; 201 substrate supply and take-out member; 300 resin material transportation and supply mechanism; 301 resin material; 302 resin material transportation and supply member; 400 substrate before resin-sealing and resin-molding; 400a end portion; 402 substrate after resin-sealing and resin-molding (resin-sealed and resin-molded product); 500 pressure reduction mechanism; 501, 502, 502a sealing member; and 503, 504, 505 exhaust path.

### BEST MODES FOR CARRYING OUT THE INVENTION

A resin-sealing and resin-molding apparatus in an embodiment includes a resin-sealing and resin-molding portion 100, a substrate supply and take-out mechanism 200, and a resin material transportation and supply mechanism 300. Resin-sealing and resin-molding portion 100 resin-seals and resin-molds an electronic component on a substrate. Substrate supply and take-out mechanism 200 transports and supplies the substrate before resin-sealing and resin-molding to a prescribed position which will be described later in resin-sealing and resin-molding portion 100, takes out the resin-sealed and resin-molded substrate from resin-sealing and resin-molding portion 100, and carries the substrate out of resin-sealing and resin-molding portion 100. Resin material transportation and supply mechanism 300 transports and supplies the resin material to a prescribed position which will be described later in resin-sealing and resin-molding portion 100.

In addition, resin-sealing and resin-molding portion 100 includes a die assembly 110, a die unfastening and fastening mechanism 120, a pressing mechanism 130, a pot block 140, and a reciprocating drive mechanism 150. Die assembly 110 is a member for resin-sealing and resin-molding the electronic component. Die unfastening and fastening mechanism 120 is a member for unfastening and clamping die assembly 110. Pressing mechanism 130 is a pressure application apparatus for applying required clamping pressure to die assembly 110 while die assembly 110 is clamped. Pot block 140 is a member for supplying the resin material, that is arranged on the side of die assembly 110. Reciprocating drive mechanism 150 is a member disposed such that pot block 140 is freely joined to and separated from a side surface 110a of die assembly 110.

In addition, die assembly 110 includes a first die 111 having a first die surface and a second die 112 having a second die surface. Resin-sealing and resin-molding portion 100 includes at least one die assembly 110, and the drawing shows an example where two die assemblies 110 including first die 111 and second die 112 are arranged in a vertically stacked manner.

In addition, the first die surface in first die 111 serves as a die matching surface (P.L surface). Namely, the first die surface is a set surface 113 serving as a substrate supply portion to which a substrate 400 is supplied, provided in first die 111. Set surface 113 serves as a single-substrate supply portion for setting single substrate 400 to which an electronic component (not shown) has been attached. In other words, only one substrate 400 is supplied and set on set surface 113 in one die assembly 110 described above. In addition, a step for substrate positioning, that has been provided in a conventional die surface in a recessed shape or the like, is not provided in set surface 113. Therefore, set surface 113 is formed in a planar shape. On the other hand, a cavity 114 for resin-molding is provided in a die surface of second die 112 (second die surface) disposed opposed to set surface 113 of first die 111. In addition, side surface 110a of die assembly 110 when first die 111 and second die 112 are clamped to each other communicates with cavity 114 through a passage 115 for transferring a molten resin material.

In addition, a pin 116 for substrate positioning in a required shape and required number may be set up at a prescribed position in the first die surface of first die 111 (set surface 113 of the substrate). Moreover, in the second die surface of second die 112, a pin hole (not shown) for fitting pin 116 in the number corresponding to the number of pins 116 may be disposed at a position corresponding to that of pin 116. It is thus ensured that substrate 400 is guided to a prescribed position in set surface 113 and set to that position.

It is noted that the prescribed position above refers to a position where an end portion (end surface) 400a of substrate 400 and side surface 110a of die assembly 110 are positioned flush with each other. Here, as there is no gap between end portion 400a of the substrate before resin-sealing and side surface 110a of die assembly 110, in the resin-sealing and resin-molding step, such a detrimental effect that a part of the molten resin material is introduced to the bottom surface side of substrate 400 to form resin flash on that substrate surface can efficiently and reliably be prevented.

A pressure reduction mechanism 500 capable of rapidly producing a pressure-reduced, vacuum state in a space formed in the die matching surface (P.L surface) of die assembly 110 and in a pot 141 is disposed.

Pressure reduction mechanism 500 is provided to rapidly produce a pressure-reduced, vacuum state in the space formed in the die matching surface (P.L surface) of the die including cavity 114 for molding as well as in pot 141 after completion of the step of clamping die assembly 110 and the step of joining pot block 140 to side surface 110a of die assembly 110.

Specifically, pot 141 communicates with a vacuum source (not shown) directly or through an exhaust path (not shown). Accordingly, when the vacuum source is actuated, the pressure in pot 141 is reduced and air or the like that remains inside is forcibly suctioned and exhausted to the outside through the exhaust path.

In addition, an elongated sealing member 501 having required heat resistance and elasticity and disposed to cover a perimeter of substrate 400 supplied to set surface 113 of first die 111 is provided on the second die surface of second die 112.

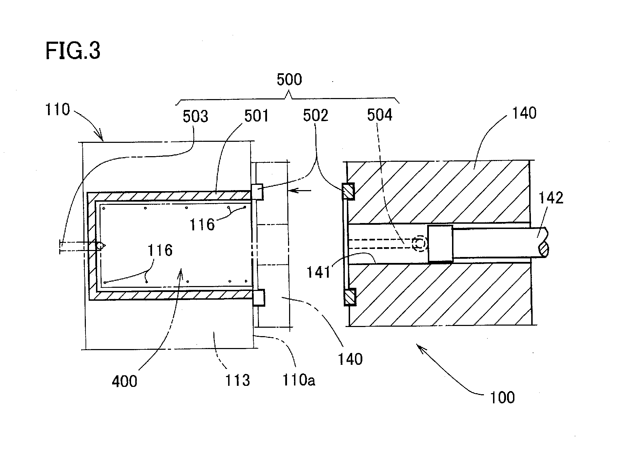

Sealing member 501 has a height greater than a thickness of substrate 400 and projects toward set surface 113 side of first die 111. In addition, opposing end surfaces of sealing member 501 are arranged at positions in the same plane as where side surface 110a of die assembly 110 is located. Therefore, sealing member 501 is provided to cover positions on the sides of substrate 400 except for side surface 110a side of die assembly 110 (in the drawing, positions on three surface sides except for end portion 400a side of substrate 400) (see Fig. 3).

In addition, on the front end portion of pot block 140 on side surface 110a side of die assembly 110, a rectangular sealing member 502 for joint to side surface 110a of die assembly 110 is disposed.

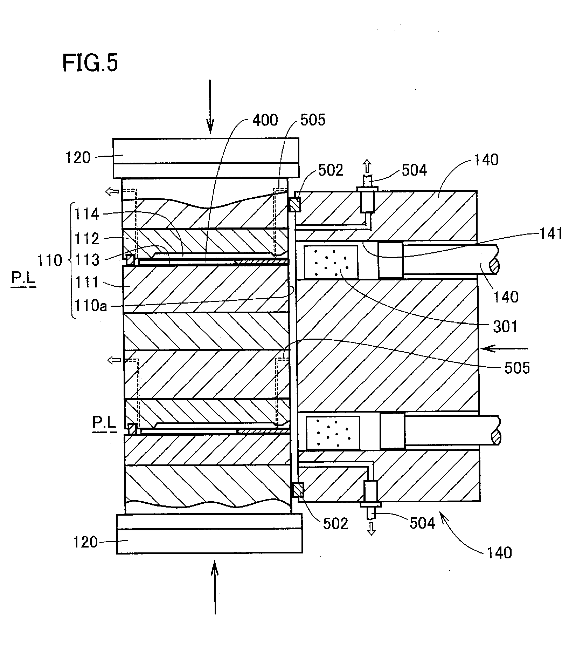

Sealing member 502 has required heat resistance and elasticity as in the case of sealing member 501 provided on the second die surface of second die 112 of die assembly 110. Then, when pot block 140 is moved for joint to side surface 110a of die assembly 110, pot block 140 is joined to both end surfaces of sealing member 501 provided on the second die surface of second die 112 of die assembly 110. In addition, sealing member 502 is arranged such that it is joined to surround the first die surface of first die 111 and the second die surface of second die 112. Therefore, in die-matching (clamping) of first die 111 and second die 112 and joint of pot block 140 to side surface 110a of die assembly 110, a space formed between the die-matching surfaces of die assembly 110 and between side surfaces 110a of both dies and the front surface position of pot block 140 is covered with both sealing members 501 and 502. Accordingly, this space is set to a state shut off from the outside (see Fig. 5).

In addition, the space shut off from the outside by sealing member 501 communicates with and is connected to the vacuum source (not shown) side through an exhaust path 503. Moreover, the space shut off from the outside by sealing member 502 communicates with and is connected to the vacuum source (not shown) through an exhaust path 504. Accordingly, when these vacuum sources are actuated, remaining air or the like in these spaces shut off from the outside by these sealing members 501 and 502 is forcibly suctioned and exhausted to the outside through these exhaust paths 503 and 504.

Therefore, these sealing members 501 and 502, these exhaust paths 503 and 504 and the vacuum sources form pressure reduction (vacuum) mechanism 500.

It is noted that pressure reduction mechanism 500 does not necessarily have to include sealing members 501 and 502. In such a case, for example, the die-matching surface (P.L surface) of die assembly 110, the joint surface between side surface 110a of die assembly 110 and the end surface of pot block 140, and a fitting surface between pot 141 and a plunger 142 fitted thereto are surface-treated with a resin coating layer having a sealing function, such as PTFE (polytetrafluoroethylene), PFA (tetrafluoroethylene), or PEEK (polyether ether ketone).

Therefore, according to this structure, a sealing function and effect at each site can be attained more efficiently and reliably without using a sealing member such as a conventional O-ring.

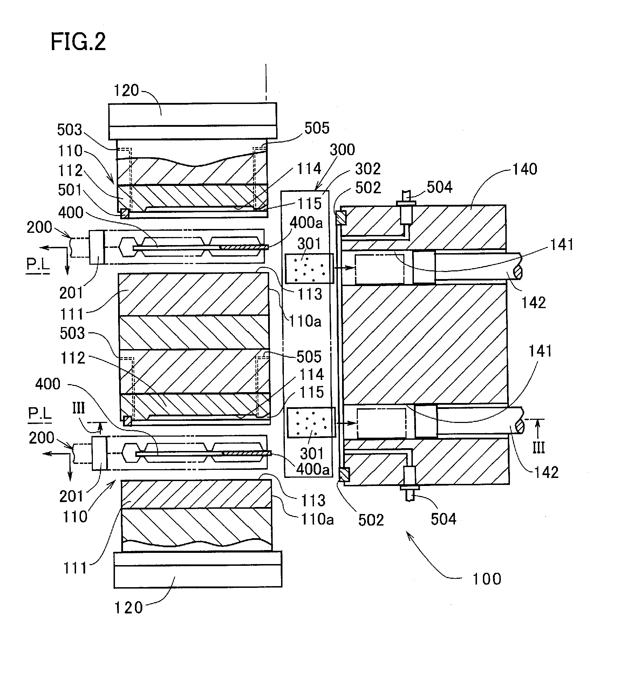

Alternatively, as shown in Fig. 2, pressure reduction mechanism 500 may include an exhaust path 505 in addition to or instead of exhaust path 504. Specifically, exhaust path 505 is connected to a path for injecting the molten resin material (in the drawing, passage 115 for transferring resin) provided between pot 141 and cavity 114 of die assembly 110 during clamping of die assembly 110. Exhaust path 505 and exhaust path 503 connected to an exhaust path, that are provided between cavity 114 of die assembly 110 and the outside of die assembly 110, are connected to exhaust outlets that communicate with the vacuum source side through appropriate exhaust paths (not shown), respectively.

Therefore, in this case, at any timing of after the step of clamping die assembly 110 and after completion of the step of joining pot block 140 to side surface 110a of die assembly 110, a function and effect of exhaustion from each site can efficiently and reliably be attained. Accordingly, the space formed in the die-matching surface (P.L surface) of die assembly 110 including cavity 114 and in pot 141 can rapidly be set to a pressure-reduced, vacuum state.

It is noted that opening and closing means such as a spring member or a pressing and moving member for opening and closing an opening portion that communicates with the outside of pot block 140 may be provided in exhaust paths 503, 504 and 505.

In addition, die unfastening and fastening mechanism 120 is a mechanism for simultaneously unfastening or clamping two die assemblies 110 arranged in a vertically stacked (layered) manner, and the drawing shows a structure that an appropriate drive mechanism of an oil hydraulic, pneumatic or electrical type moves one side of first die 111 or second die 112 in up and down directions.

Alternatively, an appropriate die unfastening and fastening mechanism utilizing what is called a rack and pinion mechanism or a crank mechanism may be adopted as die unfastening and fastening mechanism 120.

In addition, pressing mechanism 130 is a mechanism for applying a required clamping pressure to the die while die assembly 110 is clamped, and pressing mechanism 130 is provided with appropriate pressing means of an oil hydraulic, pneumatic or electrical type.

For example, die unfastening and fastening mechanism 120 and pressing mechanism 130 may be driven by the same drive source. Alternatively, die unfastening and fastening mechanism 120 and pressing mechanism 130 may be implemented by the same mechanism, by providing functions of both of die unfastening and fastening mechanism 120 and pressing mechanism 130.

In addition, pot block 140 is arranged on the side of die assembly 110. Moreover, pot block 140 is provided such that it is freely joined to and separated from side surface 110a of die assembly 110 by reciprocating drive mechanism 150, die assembly 110 being in such a clamped state that the die-matching surfaces (P.L surfaces) thereof are matched.

Pot block 140 includes pot 141, plunger 142, the reciprocating drive mechanism (not shown), and a heater (not shown). Pots 141 are members for supplying the resin material, that are arranged in the number corresponding to the number of the vertically-arranged, two die assemblies 110 and at positions corresponding to those of the die-matching surfaces (P.L surface) thereof. Plunger 142 is a member for applying pressure to the resin material supplied into pot 141. The reciprocating drive mechanism is an appropriate mechanism for causing plunger 142 to carry out reciprocating motion. The heater is an appropriate heating member for heating and melting resin material 301 supplied into pot 141.

Therefore, according to this structure, reciprocating drive mechanism 150 for pot block 140 can move entire pot block 140 to a position where the first die surface and the second die surface of die assembly 110 are matched so that pot block 140 is joined thereto, and can move pot block 140 backward to separate the same. In addition, by moving plunger 142 backward by means of reciprocating drive mechanism 150 for plunger 142, inside of a front end opening portion in pot 141 can serve as a space for supplying resin material 301 (see Fig. 2). Moreover, by moving plunger 142 forward from the position in the back, pressure can be applied to resin material 301 supplied into pot 141.

In addition, by joining the die-matching surfaces (P.L surfaces) of first die 111 and second die 112 of die assembly 110 to pot 141 in pot block 140 for establishing communication (see Fig. 5) and applying pressure with plunger 142 to resin material 301 within pot 141 heated and molten by the heater, molten resin material 301 within pot 141 can directly be injected and charged into cavity 114 through transfer passage 115.

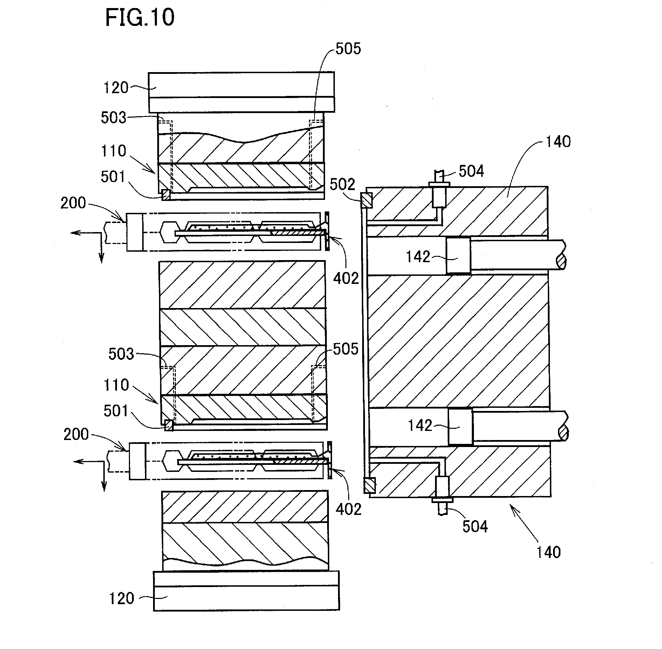

In addition, substrate supply and take-out mechanism 200 carries substrate before resin-sealing and resin-molding 400 to a prescribed position in resin-sealing and resin-molding portion 100, that is, in between first die 111 and second die 112 in each of the upper and lower, two unfastened die assemblies 110, by using a substrate supply and take-out member 201 including an appropriate catching mechanism (not shown) such as a catching chuck or the like. Moreover, substrate supply and take-out mechanism 200 is provided such that substrate 400 can be set onto set surface 113 of first die 111. Further, substrate supply and take-out mechanism 200 catches and takes out a substrate after resin-sealing and resin-molding 402 (to serve as the resin-sealed and resin-molded product; see Fig. 10) from set surface 113 that has been exposed after resin-sealing and resin-molding, by using the catching mechanism. In addition, substrate supply and take-out mechanism 200 is provided such that substrate 402 can be carried out from in between first die 111 and second die 112 in each of upper and lower, two die assemblies 110.

Therefore, according to this structure, substrate before resin-sealing and resin-molding 400 can be set at the prescribed position in resin-sealing and resin-molding portion 100 and substrate after resin-sealing and resin-molding 402 can be taken out of resin-sealing and resin-molding portion 100.

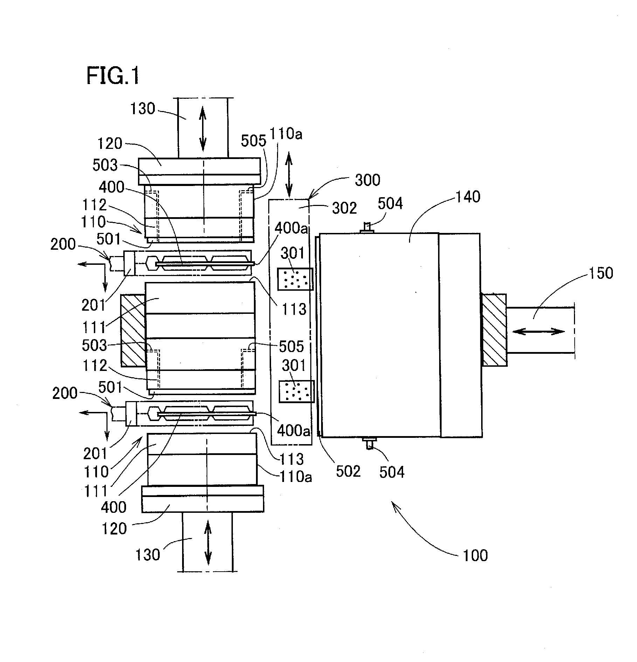

In addition, resin material transportation and supply mechanism 300 uses a resin material transportation and supply member 302 to supply resin material 301 to a prescribed position in resin-sealing and resin-molding portion 100. Namely, resin material transportation and supply mechanism 300 is provided such that pot block 140 and plunger 142 are moved backward to required positions (see Fig. 1) and resin material 301 can be supplied into the space provided in the front end opening portion in pot 141.

It is noted that resin material transportation and supply member 302 is provided with hole portions for charging the resin material, arranged in the number corresponding to the number of upper and lower, two die assemblies 110 and at positions corresponding to the positions of the die-matching surfaces (P.L surfaces), an extrusion member for extruding and supplying resin material 301 charged into the hole portion into pot 141, and the like.

Therefore, according to such a structure, pot block 140 is moved backward to the required position so that resin material 301 can be supplied into respective pots 141 in pot block 140.

Resin-sealing and resin-molding of the electronic component in the present embodiment is performed, for example, in the following manner.

Initially, in a state that upper and lower, two die assemblies 110 shown in Figs. 1 and 2 are unfastened, substrate supply and take-out mechanism 200 carries substrate before resin-sealing and resin-molding 400 in between first die 111 and second die 112 and sets substrate 400 onto set surface 113 of first die 111. Thereafter or concurrently, entire pot block 140 is moved backward away from side surface 110a of die assembly 110 by using reciprocating drive mechanism 150 for the pot block and plunger 142 is moved backward by the reciprocating drive mechanism for the plunger, so that the space for supplying resin material 301 is formed in the front end opening portion in pot 141. Then, resin material 301 is supplied into the space by using resin material transportation and supply member 302 (see Fig. 2).

Then, clamping of upper and lower, two die assemblies 110 is started by using die unfastening and fastening mechanism 120.

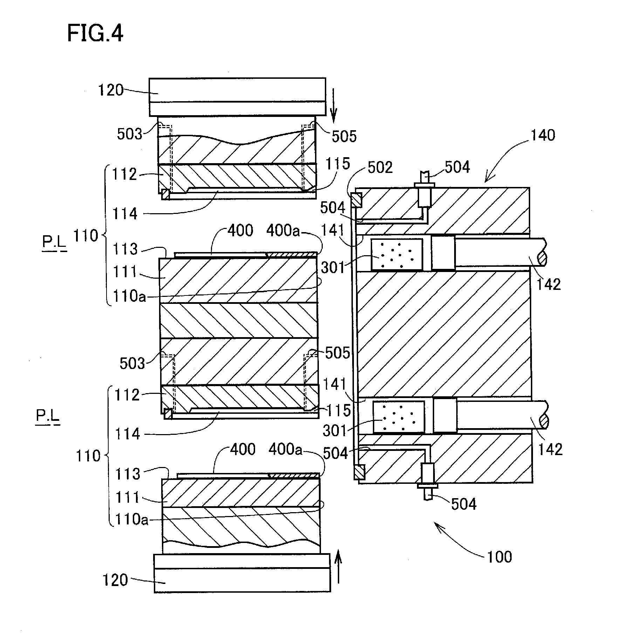

Thereafter or concurrently, reciprocating drive mechanism 150 for the pot block moves forward entire pot block 140 to side surface 110a of the die, so as to join the front end surface thereof to side surface 110a of die assembly 110. When sealing member 502 is arranged on pot block 140, sealing member 502 at the front end portion of pot block 140 is joined to side surface 110a of die assembly 110 (see Figs. 4 and 5).

In addition, after the step of clamping die assembly 110 and the step of joining pot block 140 to side surface 110a of die assembly 110, pressure reduction by pressure reduction mechanism 500 is performed. In this step, air or the like that remains in the die-matching surface (P.L surface) of die assembly 110 (for example, not only air and moisture in the atmosphere but also a gas generated during heating and melting of a resin material) is exhausted as a result of forced and rapid suction thereof to the outside of die assembly 110 through passage 115 for transferring the resin that serves as the path for injecting the molten resin material and through exhaust paths 503 and 504 connected to the exhaust path (or exhaust paths 503 and 505 or exhaust paths 503, 504 and 505). Moreover, at the same time, air or the like that remains within pot 141 is exhausted as a result of forced and rapid suction to the outside of die assembly 110 through the exhaust path connected to the inside of pot 141.

When pressure reduction mechanism 500 includes sealing members 501 and 502, in this step, remaining air or the like in the space shut off from the outside by sealing members 501 and 502 is forcibly suctioned and exhausted to the outside through exhaust paths 503 and 504.

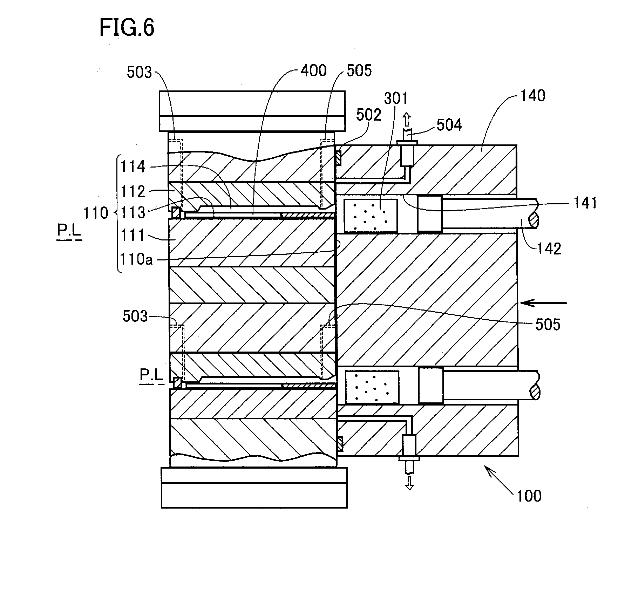

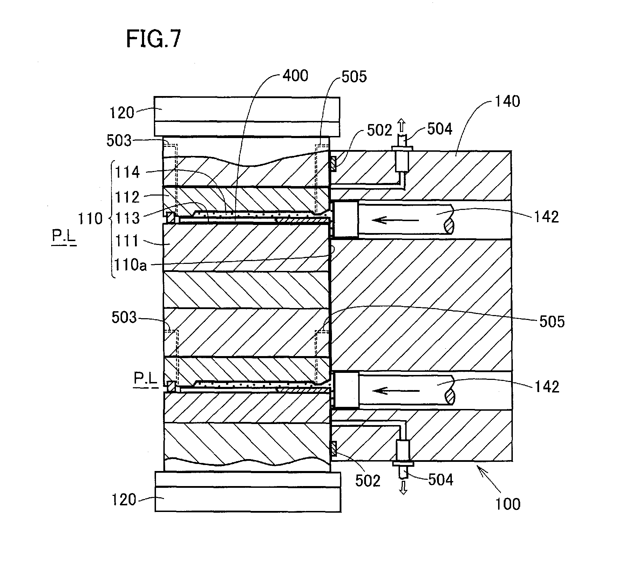

Moreover, this pressure reduction step for producing vacuum is preferably continued also during complete clamping and resin-sealing and resin-molding (see Figs. 6 and 7) that are successively performed after intermediate (or preliminary) clamping as shown in Fig. 5.

As shown in Fig. 6, when complete clamping of upper and lower, two die assemblies 110 is performed, pressing force by the pressing means in pressing mechanism 130 is applied to each die assembly 110, and a uniform clamping pressure is simultaneously applied to respective die assemblies 110 arranged in a stacked manner.

In addition, when pot block 140 is completely joined to side surface 110a of die assembly 110, die matching surfaces of first die 111 and second die 112 in each die assembly 110 are joined to pots 141 in pot block 140 to establish a communicated state, and resin material 301 supplied into pot 141 is heated and molten with the heater. Therefore, by moving plunger 142 forward and applying pressure to resin material 301 within pot 141, the molten resin material is directly injected into cavity 114 through transfer passage 115. The electronic component on substrate 400 fitted into cavity 114 can thus be resin-sealed and resin-molded (see Fig. 7).

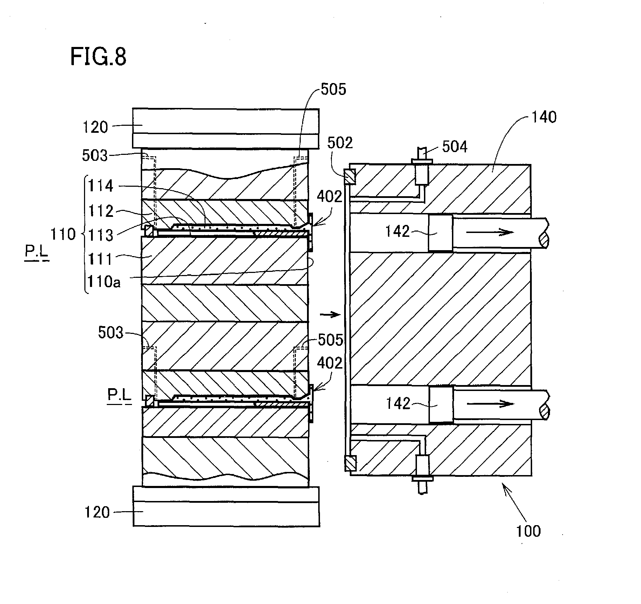

Then, after a required curing time elapses, reciprocating drive mechanism 150 for the pot block moves pot block 140 backward in a direction away from side surface 110a of die assembly 110 (see Fig. 8).

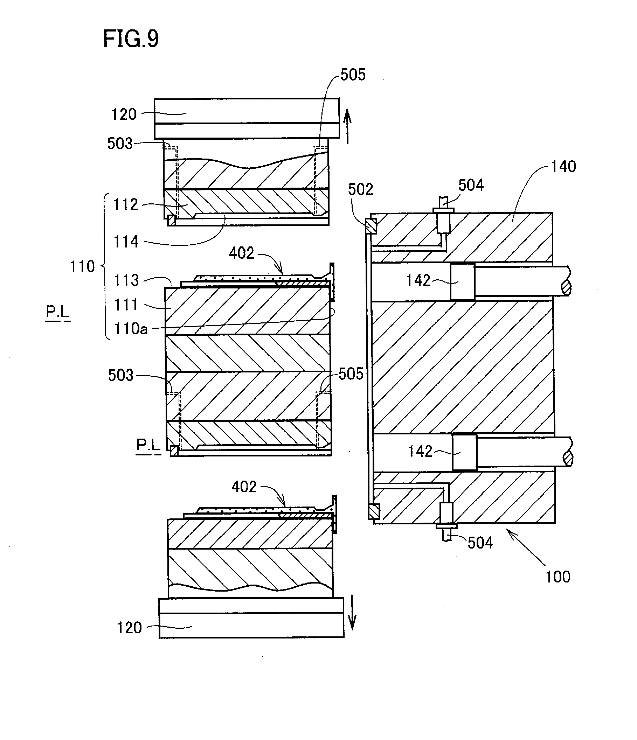

Thereafter or concurrently, the clamping pressure applied by the pressing means of pressing mechanism 130 to upper and lower, two die assemblies 110 is released and die unfastening and fastening mechanism 120 unfastens upper and lower, two die assemblies 110 (see Figs. 8 and 9).

Then, the catching mechanism of substrate supply and take-out mechanism 200 catches and takes out substrate after resin-sealing and resin-molding 402 (resin-sealed and resin-molded product) from exposed set surface 113 and carries this substrate 402 to the outside (see Fig. 10).

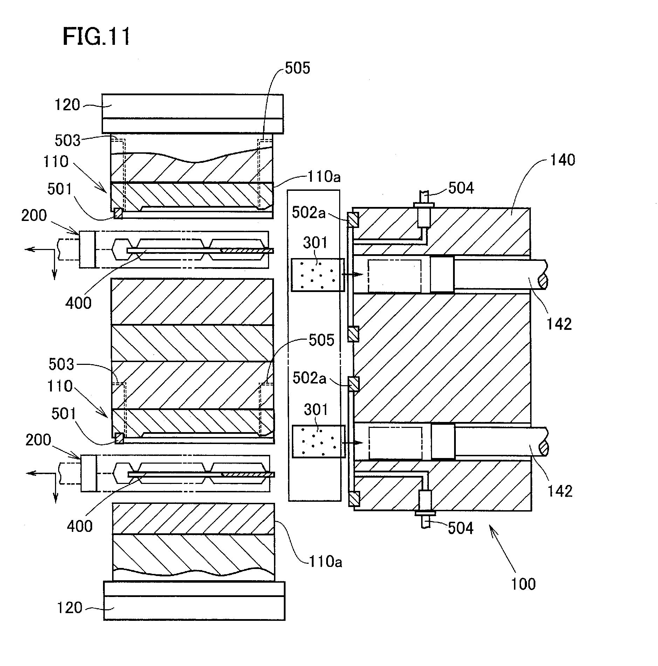

Fig. 11 shows another exemplary shape and another exemplary structure of sealing member 502 disposed at the front end portion of pot block 140.

Specifically, sealing member 502 shown in Fig. 2 is provided in such a shape as being simultaneously joined to entire sealing member 501 disposed on side surface 110a of die assembly 110. On the other hand, a sealing member 502a shown in Fig. 11 is different in that it is provided in such a shape as being joined individually to each sealing member 501 disposed on side surface 110a of die assembly 110.

The sealing member of such a shape can clearly obtain the function and effect similar to that of sealing member 502 described above.

### INDUSTRIAL APPLICABILITY

The method and the apparatus for resin-sealing and resin-molding the electronic component according to the present invention are useful in resin-sealing and resin-molding the electronic component on the substrate included in a semiconductor device.

## Claims

1. A method of resin-sealing and resin-molding an electronic component, comprising:
a preparation step of preparing a resin-molding apparatus including a die assembly (110) including a first die (111) having a first die surface and a second die (112) having a second die surface opposed to said first die surface and a cavity (114) receiving an electronic component;
a supply step of setting a substrate before resin-sealing (400), to which the electronic component has been attached, to said first die surface;
a clamping step of inserting the electronic component and a peripheral portion thereof on said substrate before resin-sealing (400) into said cavity (114) by clamping said die assembly (110);
a joint step of joining a pot block (140) for injecting a resin material to a side surface of said die assembly (110);
a pressure reduction step of producing vacuum in a space formed between said first die surface, said second die surface and said pot block (140) after said joint step;
an injection step of directly injecting the resin material (301) from said pot block (140) into said cavity (114);
a separation step of separating said pot block (140) from said die assembly (110);
a molding step of sealing the electronic component and the peripheral portion thereof fitted into said cavity (114) with said resin material (301) by curing said resin material (301); and
a die unfastening step of unfastening said first die (111) and said second die (112) after said molding step and taking out a substrate after resin-sealing (402) after said molding step.

2. The method of resin-sealing and resin-molding an electronic component according to claim 1, wherein
in said supply step, a single substrate before resin-sealing and resin-molding (400) is supplied in between said first die surface (111) and said second die surface (112).

3. The method of resin-sealing and resin-molding an electronic component according to claim 1, wherein
in said supply step, an end surface of said substrate before resin-sealing (400) and a side surface (110a) of said die assembly (110) are positioned flush with each other.

4. The method of resin-sealing and resin-molding an electronic component according to claim 2, wherein
in said preparation step of preparing the die assembly, a resin-molding apparatus in which a plurality of said die assemblies (110) are arranged in a stacked manner is prepared, and
in said clamping step, pressure is simultaneously applied to said plurality of die assemblies (110).

5. An apparatus for resin-sealing and resin-molding an electronic component, comprising:
a first die (111) having a first die surface, to which a substrate (400) carrying the electronic component is attached;
a second die (112) having a second die surface opposed to said first die surface and having a cavity (114) receiving said electronic component;
a pot block (140) injecting a resin material (301) through a side surface of a die assembly (110) while said die assembly (110) including said first die (111) and said second die (112) is fastened; and
a pressure reduction mechanism (500) producing vacuum in a space formed between said first die surface, said second die surface and said pot block (140) when said resin material (301) is injected.

6. The apparatus for resin-sealing and resin-molding an electronic component according to claim 5, wherein
a substrate supply portion (113) supplied with a single said substrate before resin-sealing (400) is provided in said first die (111).

7. The apparatus for resin-sealing and resin-molding an electronic component according to claim 5, wherein
a supply mechanism (200) supplying said substrate before resin-sealing (400) such that an end surface (400a) of said substrate before resin-sealing (400) and a side surface (110a) of said die assembly (110) are positioned flush with each other in supplying said substrate before resin-sealing (400) into said cavity (114) is provided.

8. The apparatus for resin-sealing and resin-molding an electronic component according to claim 6, wherein
a plurality of said die assemblies (110) are arranged in a stacked manner, and a pressure application apparatus (130) simultaneously applying pressure to said plurality of die assemblies (110) is provided.

9. The apparatus for resin-sealing and resin-molding an electronic component according to claim 5, wherein
said pot block (140) includes a pot (141) containing said resin material (301) and a plunger (142) pushing said resin material (301) supplied into said pot (141) into said cavity (114), and
the apparatus for resin-sealing and resin-molding an electronic component further comprises a resin coating layer having a sealing function at said first die surface, said second die surface, and a joint surface between said pot block (140) and the die assembly (110) including said first die (111) and said second die (112).

10. The apparatus for resin-sealing and resin-molding an electronic component according to claim 5 or 9, wherein
said pressure reduction mechanism (500) includes an exhaust path connected to said space and provided in said pot block (140).

## Amended claims

### Amended claims under Art. 19.1 PCT

**1.** A method of resin-sealing and resin-molding an electronic component, comprising:
a preparation step of preparing a die assembly (110) including a first die (111) having a first die surface and a second die (112) having a second die surface opposed to said first die surface and a cavity (114) receiving said electronic component;
a preparation step of preparing a pot block (140) capable of supplying a resin material (301) to said die assembly (110);
a supply step of setting a substrate before resin-sealing (400), to which said electronic component has been attached, to said first die surface, and supplying said resin material (301) into a pot (141) provided in said pot block (140);
a clamping step of inserting the electronic component and a peripheral portion thereof on said substrate before resin-sealing (400) into said cavity (114) by clamping said die assembly (110);
a joint step of joining said pot block (140) to a side surface of said die assembly (110);
a pressure reduction step of producing vacuum in a space formed between said first die surface, said second die surface and said pot block (140) after said joint step;
an injection step of directly injecting the resin material (301) from said pot (141) in said pot block (140) into said cavity (114);
a separation step of separating said pot block (140) from said die assembly (110);
a molding step of sealing the electronic component and the peripheral portion thereof fitted into said cavity (114) with said resin material (301) by curing said resin material (301); and
a die unfastening step of unfastening said first die (111) and said second die (112) after said molding step and taking out a substrate after resin-sealing (402) after said molding step.

**2.** The method of resin-sealing and resin-molding an electronic component according to claim 1, wherein
in said supply step, a single substrate before resin-sealing and resin-molding (400) is supplied in between said first die surface (111) and said second die surface (112).

**3.** The method of resin-sealing and resin-molding an electronic component according to claim 1, wherein
in said supply step, an end surface of said substrate before resin-sealing (400) and a side surface (110a) of said die assembly (110) are positioned flush with each other.

**4.** The method of resin-sealing and resin-molding an electronic component according to claim 2, wherein
in said preparation step of preparing the die assembly, a resin-molding apparatus in which a plurality of said die assemblies (110) are arranged in a stacked manner is prepared, and
in said clamping step, pressure is simultaneously applied to said plurality of die assemblies (110).

**5.** An apparatus for resin-sealing and resin-molding an electronic component, comprising:
a first die (111) having a first die surface, to which a substrate (400) carrying the electronic component is attached;
a second die (112) having a second die surface opposed to said first die surface and having a cavity (114) receiving said electronic component;
a pot block (140) that includes a pot (141) capable of containing a resin material (301) and can be attached to a side surface of a die assembly (110) while said die assembly (110) including said first die (111) and said second die (112) is fastened, for directly injecting said resin material (301) from said pot (141) into said cavity; and
a pressure reduction mechanism (500) producing vacuum in a space formed between said first die surface, said second die surface and said pot block (140) when said resin material (301) is directly injected.

**6.** The apparatus for resin-sealing and resin-molding an electronic component according to claim 5, wherein
a substrate supply portion (113) supplied with a single said substrate before resin-sealing (400) is provided in said first die (111).

**7.** The apparatus for resin-sealing and resin-molding an electronic component according to claim 5, wherein
a supply mechanism (200) supplying said substrate before resin-sealing (400) such that an end surface (400a) of said substrate before resin-sealing (400) and a side surface (110a) of said die assembly (110) are positioned flush with each other in supplying said substrate before resin-sealing (400) into said cavity (114) is provided.

**8.** The apparatus for resin-sealing and resin-molding an electronic component according to claim 6, wherein
a plurality of said die assemblies (110) are arranged in a stacked manner, and a pressure application apparatus (130) simultaneously applying pressure to said plurality of die assemblies (110) is provided.

**9.** The apparatus for resin-sealing and resin-molding an electronic component according to claim 5, wherein
said pot block (140) further includes a plunger (142) pushing said resin material (301) supplied into said pot (141) into said cavity (114), and
the apparatus for resin-sealing and resin-molding an electronic component further comprises a resin coating layer having a sealing function at said first die surface, said second die surface, and a joint surface between said pot block (140) and the die assembly (110) including said first die (111) and said second die (112).

**10.** The apparatus for resin-sealing and resin-molding an electronic component according to claim 5 or 9, wherein
said pressure reduction mechanism (500) includes an exhaust path connected to said space and provided in said pot block (140).
